# EUROPEAN PATENT APPLICATION

(11) **EP 3 300 063 A1**
(43) Date of publication of application: **28.03.2018**
(21) Application number: 17193119.9
(22) Date of filing: 26.09.2017
(51) Int. Cl.: G09G 3/32, H01L 27/32, G09F 9/30

(54) **ORGANIC LIGHT EMITTING DISPLAY PANEL AND TILING DISPLAY DEVICE INCLUDING THE SAME**

(30) Priority: 27.09.2016 KR 20160124217
(71) Applicant: LG Display Co., Ltd., Seoul 07336 (KR)
(72) Inventor: LEE, DongHo, 10845 Paju-si, Gyeonggi-do (KR); KIM, TaeKyun, 10845 Paju-si, Gyeonggi-do (KR)
(74) Representative: Viering, Jentschura & Partner mbB Patent- und Rechtsanwälte

(57) **Abstract**

Disclosed are an organic light emitting display panel (100, 200, 300, 400) and a tiling display device including first to fourth organic light emitting display devices including, respectively, first to fourth organic light emitting display panels (100, 200, 300, 400), in which corners (X1-2, X2-3, X3-4, X4-1) of non-display areas of the first to fourth organic light emitting display panels (100, 200, 300, 400), which are adjacent to one another, are cut.

## Description

### CROSS-REFERENCE TO RELATED APPLICATIONS

This application claims the benefit of the Korean Patent Application No. 10-2016-0124217 filed on September 27, 2016.

### BACKGROUND

### Field of the Invention

The present disclosure relates to a tiling display device including a plurality of organic light emitting display devices.

### Discussion of the Related Art

Flat panel display (FPD) devices are applied to various kinds of electronic products such as portable phones, tablet personal computers (PCs), notebook computers, etc. Examples of the FPD devices include liquid crystal display (LCD) devices, organic light emitting display devices, etc. Recently, electrophoretic display (EPD) devices are being widely used as one type of the FPD device.

In such FPD devices (hereinafter simply referred to as a display device), the organic light emitting display devices have a fast response time of 1 ms or less and low power consumption, and thus are attracting much attention as next generation display devices.

Moreover, since a thickness of each of the organic light emitting display devices is very thinly provided, the organic light emitting display devices may be attached on a wall surface, etc. Therefore, the organic light emitting display devices may be applied to tiling display devices.

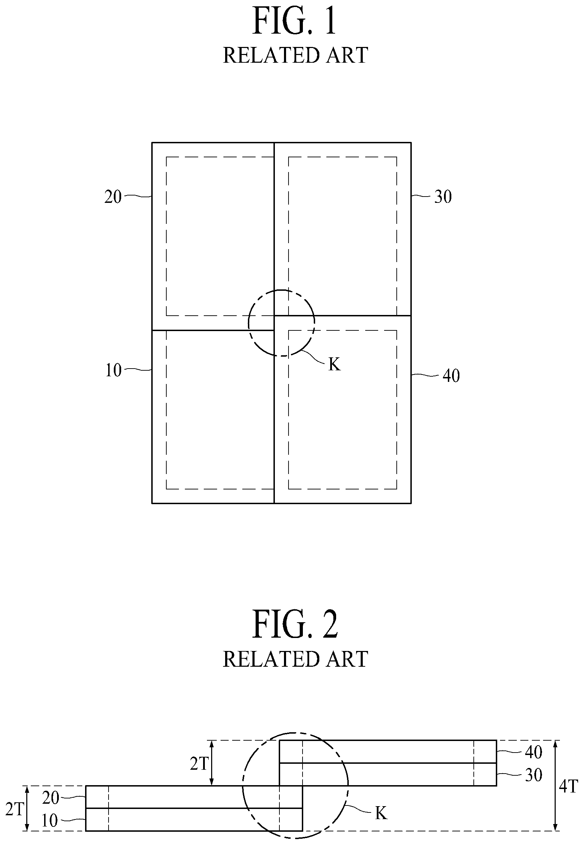

FIG. 1 is a plan view of a related art tiling display device, and FIG. 2 is a side view of the related art tiling display device.

The related art tiling display device may include, for example, at least four organic light emitting display devices.

The four organic light emitting display devices configuring the tiling display device may be disposed on the same plane and may not overlap one another.

However, if the four organic light emitting display devices are disposed on the same plane, a seam area having a width corresponding to twice a width of a non-display area of one organic light emitting display device is provided between two organic light emitting display devices adjacent to each other. The seam area denotes an area where an image is not displayed when two organic light emitting display devices are disposed. For example, as described above, if two organic light emitting display devices are disposed on the same plane and do not overlap each other, the width of the seam area is twice the width of the non-display area each of the two organic light emitting display devices. As the width of the seam area is reduced, a good-quality image is displayed.

However, as described above, in the tiling display device where the four organic light emitting display devices are disposed not to overlap one another, since the width of the seam area corresponds to twice the width of the non-display device, a good-quality image cannot be displayed.

In order to such a problem, in the related art tiling display device, non-display areas of the four organic light emitting display devices are disposed to overlap one another.

For example, as illustrated in FIGS. 1 and 2, a second organic light emitting display device 20 may be disposed on a first organic light emitting display device 10, a third organic light emitting display device 30 may be disposed on the second organic light emitting display device 20, and a fourth organic light emitting display device 40 may be disposed on the third organic light emitting display device 30.

Therefore, a width of a seam area in the tiling display device illustrated in FIG. 1 may be half (1/2) of a width of a seam area in a tiling display device where all organic light emitting display devices are disposed on the same plane.

In this case, however, the four organic light emitting display devices 10, 20, 30, and 40 overlap one another in a center area K of the tiling display device, and two organic light emitting display devices overlap each other in the other area.

Therefore, when it is assumed that a thickness of one organic light emitting display device is T, as illustrated in FIG. 2, a thickness of an overlap area K where the four organic light emitting display devices 10, 20, 30, and 40 overlap one another becomes 4T, and a thickness of an area where two organic light emitting display devices overlap each other becomes 2T.

For this reason, a thickness deviation occurs in the overlap area K and a portion other than the overlap area K. Due to the thickness deviation, a deviation based on a sense of distance can occur.

To provide an additional description, when the four organic light emitting display devices configuring the tiling display device do not overlap one another, the width of the seam area increases, and for this reason, the quality of an image is degraded. Also, if the four organic light emitting display devices overlap one another, a deviation based on a sense of distance occurs due to a thickness difference in each area, causing the degradation in quality of an image.

### SUMMARY

Accordingly, the present disclosure is directed to provide an organic light emitting display panel and a tiling display device including the same that substantially obviate one or more problems due to limitations and disadvantages of the related art.

An aspect of the present disclosure is directed to provide an organic light emitting display panel and a tiling display device including the same, in which corners of a non-display area, where four organic light emitting display devices are adjacent to one another, of non-display areas of the four organic light emitting display devices are cut.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these and other advantages and in accordance with the purpose of the disclosure, as embodied and broadly described herein, there is provided an organic light emitting display panel including a display area where a plurality of pixels each including an organic light emitting diode (OLED) are provided and a non-display area disposed outside the display area to surround the display area. The non-display area includes a first non-display area, a second non-display area, a third non-display area, and a fourth non-display area. A portion of at least one of a first corner where the first non-display area and the second non-display area are adjacent to each other, a second corner where the second non-display area and the third non-display area are adjacent to each other, a third corner where the third non-display area and the fourth non-display area are adjacent to each other, and a fourth corner where the fourth non-display area and the first non-display area are adjacent to each other is cut.

In one or more embodiments, each of two angles between both ends of a cut surface of one cut corner of the first to fourth corners and sides respectively contacting the both ends is 135 degrees.

In another aspect of the present disclosure, there is provided a tiling display device including a first organic light emitting display device, a second organic light emitting display device, a third organic light emitting display device, a fourth organic light emitting display device, and a controller controlling the first to fourth organic light emitting display devices. The first to fourth organic light emitting display devices comprise, respectively, first to fourth organic light emitting display panels. The first to fourth organic light emitting display panels each include a display area where a plurality of pixels each including an organic light emitting diode (OLED) are provided and a non-display area disposed outside the display area to surround the display area, the non-display area including a first non-display area, a second non-display area, a third non-display area, and a fourth non-display area. A portion of at least one of a first corner where the first non-display area and the second non-display area are adjacent to each other, a second corner where the second non-display area and the third non-display area are adjacent to each other, a third corner where the third non-display area and the fourth non-display area are adjacent to each other, and a fourth corner where the fourth non-display area and the first non-display area are adjacent to each other is cut.

In one or more embodiments, the fourth non-display area of the second organic light emitting display panel overlaps an upper end of the second non-display area of the first organic light emitting display panel, the first non-display area of the fourth organic light emitting display panel overlaps an upper end of the third non-display area of the first organic light emitting display panel, the third non-display area of the second organic light emitting display panel overlaps an upper end of the first non-display area of the third organic light emitting display panel, the second non-display area of the fourth organic light emitting display panel overlaps an upper end of the fourth non-display area of the third organic light emitting display panel, and a portion of the second corner of the first organic light emitting display panel, a portion of the third corner of the second organic light emitting display panel, a portion of the fourth corner of configuring the third organic light emitting display panel, and a portion of the first corner of the fourth organic light emitting display panel are cut.

In one or more embodiments, a cut surface of the second corner of the first organic light emitting display panel faces a cut surface of the fourth corner of the third organic light emitting display panel, and a cut surface of the third corner of the second organic light emitting display panel faces a cut surface of the first corner of the fourth organic light emitting display panel.

In one or more embodiments, a cut surface of the second corner of the first organic light emitting display panel is parallel with a cut surface of the fourth corner of the third organic light emitting display panel, and a cut surface of the third corner of the second organic light emitting display panel is parallel with a cut surface of the first corner of the fourth organic light emitting display panel.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a plan view of a related art tiling display device;
FIG. 2 is a side view of the related art tiling display device;
FIG. 3 is an exemplary diagram illustrating an organic light emitting display panel according to an embodiment of the present disclosure;
FIG. 4 is an exemplary diagram illustrating two organic light emitting display panels disposed on the same plane to face each other, according to an embodiment of the present disclosure;
FIG. 5 is an exemplary diagram illustrating two organic light emitting display panels disposed on the two organic light emitting display panels of FIG. 4 to face each other, according to an embodiment of the present disclosure;
FIG. 6 is an exemplary diagram illustrating a cross-sectional surface taken along line P-P' illustrated in FIG. 5; and
FIG. 7 is an exemplary diagram illustrating a tiling display device according to an embodiment of the present disclosure.

### DETAILED DESCRIPTION OF THE DISCLOSURE

Reference will now be made in detail to the exemplary embodiments of the present disclosure, examples of which are illustrated in the accompanying drawings. Wherever possible, the same reference numbers will be used throughout the drawings to refer to the same or like parts.

Advantages and features of the present invention, and implementation methods thereof will be clarified through following embodiments described with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. Furthermore, the present invention is only defined by scopes of claims.

In the specification, in adding reference numerals for elements in each drawing, it should be noted that like reference numerals already used to denote like elements in other drawings are used for elements wherever possible.

A shape, a size, a ratio, an angle, and a number disclosed in the drawings for describing embodiments of the present invention are merely an example, and thus, the present invention is not limited to the illustrated details. Like reference numerals refer to like elements throughout. In the following description, when the detailed description of the relevant known function or configuration is determined to unnecessarily obscure the important point of the present invention, the detailed description will be omitted. In a case where 'comprise', 'have', and 'include' described in the present specification are used, another part may be added unless 'only∼' is used. The terms of a singular form may include plural forms unless referred to the contrary.

In construing an element, the element is construed as including an error range although there is no explicit description.

In describing a position relationship, for example, when a position relation between two parts is described as 'on∼', 'over∼', 'under∼', and 'next∼', one or more other parts may be disposed between the two parts unless 'just' or 'direct' is used.

In describing a time relationship, for example, when the temporal order is described as 'after∼', 'subsequent∼', 'next∼', and 'before∼', a case which is not continuous may be included unless 'just' or 'direct' is used.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Features of various embodiments of the present invention may be partially or overall coupled to or combined with each other, and may be variously inter-operated with each other and driven technically as those skilled in the art can sufficiently understand. The embodiments of the present invention may be carried out independently from each other, or may be carried out together in co-dependent relationship.

Hereinafter, embodiments of the present invention will be described in detail with reference to the accompanying drawings.

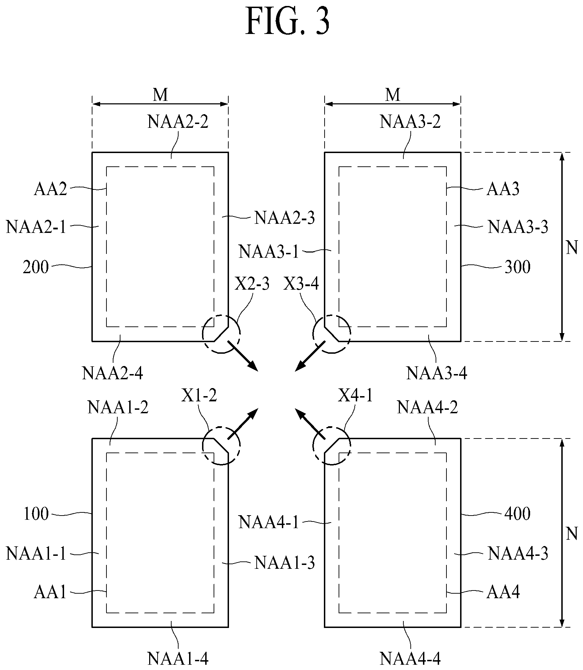

FIG. 3 is an exemplary diagram illustrating an organic light emitting display panel according to an embodiment of the present disclosure, and particularly, is an exemplary diagram illustrating four organic light emitting display panels.

The organic light emitting display panel according to an embodiment of the present disclosure may be defined by a plurality of data lines and a plurality of gate lines and may include a display area, where a plurality of pixels each including an organic light emitting diode (OLED) are provided, and a non-display area which is disposed outside the display area to surround the display area.

The organic light emitting display panel may include a plurality of subpixels. The subpixels may each include an OLED and a pixel driving circuit that drives the OLED.

A plurality of signal lines, which define an area where the subpixels are provided and supply a driving signal to the pixel driving circuit, may be respectively provided in the subpixels.

The display area may be an area, displaying an image, of the organic light emitting display panel. The display area may include the data lines, through which data voltages are supplied, and the gate lines through which a gate pulse is supplied.

The non-display area may denote an area that is disposed outside the display area to surround to the display area.

As illustrated in FIG. 3, if the organic light emitting display panel is tetragonal in shape, the non-display area may be provided on four side surfaces of the organic light emitting display panel.

The non-display area may include a first non-display area, a second non-display area, a third non-display area, and a fourth non-display area.

A portion of at least one of a first corner where the first non-display area and the second non-display area are adjacent to each other, a second corner where the second non-display area and the third non-display area are adjacent to each other, a third corner where the third non-display area and the fourth non-display area are adjacent to each other, and a fourth corner where the fourth non-display area and the first non-display area are adjacent to each other may be cut.

For example, a first organic light emitting display panel 100 illustrated in FIG. 3 may include a display area AA1 and a non-display area.

The non-display area of the first organic light emitting display panel 100 may include a first non-display area NAA1-1, a second non-display area NAA1-2, a third non-display area NAA1-3, and a fourth non-display area NAA1-4.

A portion of at least one of a first corner where the first non-display area NAA1-1 and the second non-display area NAA1-2 are adjacent to each other, a second corner X1-2 where the second non-display area NAA1-2 and the third non-display area NAA1-3 are adjacent to each other, a third corner where the third non-display area NAA1-3 and the fourth non-display area NAA1-4 are adjacent to each other, and a fourth corner where the fourth non-display area NAA1-4 and the first non-display area NAA1-1 are adjacent to each other may be cut.

In the first organic light emitting display panel 100, a portion of the second corner X1-2 may be cut.

Moreover, a second organic light emitting display panel 200 illustrated in FIG. 3 may include a display area AA2 and a non-display area.

The non-display area of the second organic light emitting display panel 200 may include a first non-display area NAA2-1, a second non-display area NAA2-2, a third non-display area NAA2-3, and a fourth non-display area NAA2-4.

A portion of at least one of a first corner where the first non-display area NAA2-1 and the second non-display area NAA2-2 are adjacent to each other, a second corner where the second non-display area NAA2-2 and the third non-display area NAA2-3 are adjacent to each other, a third corner X2-3 where the third non-display area NAA2-3 and the fourth non-display area NAA2-4 are adjacent to each other, and a fourth corner where the fourth non-display area NAA2-4 and the first non-display area NAA2-1 are adjacent to each other may be cut.

In the second organic light emitting display panel 200, a portion of the third corner X2-3 may be cut.

Moreover, a third organic light emitting display panel 300 illustrated in FIG. 3 may include a display area AA3 and a non-display area.

The non-display area of the third organic light emitting display panel 300 may include a first non-display area NAA3-1, a second non-display area NAA3-2, a third non-display area NAA3-3, and a fourth non-display area NAA3-4.

A portion of at least one of a first corner where the first non-display area NAA3-1 and the second non-display area NAA3-2 are adjacent to each other, a second corner where the second non-display area NAA3-2 and the third non-display area NAA3-3 are adjacent to each other, a third corner where the third non-display area NAA3-3 and the fourth non-display area NAA3-4 are adjacent to each other, and a fourth corner X3-4 where the fourth non-display area NAA3-4 and the first non-display area NAA3-1 are adjacent to each other may be cut.

In the third organic light emitting display panel 300, a portion of the fourth corner X3-4 may be cut.

Finally, a fourth organic light emitting display panel 400 illustrated in FIG. 3 may include a display area AA4 and a non-display area.

The non-display area of the fourth organic light emitting display panel 400 may include a first non-display area NAA4-1, a second non-display area NAA4-2, a third non-display area NAA4-3, and a fourth non-display area NAA4-4.

A portion of at least one of a first corner X4-1 where the first non-display area NAA4-1 and the second non-display area NAA4-2 are adjacent to each other, a second corner where the second non-display area NAA4-2 and the third non-display area NAA4-3 are adjacent to each other, a third corner where the third non-display area NAA4-3 and the fourth non-display area NAA4-4 are adjacent to each other, and a fourth corner where the fourth non-display area NAA4-4 and the first non-display area NAA4-1 are adjacent to each other may be cut.

In the fourth organic light emitting display panel 400, a portion of the first corner X4-1 may be cut.

A width of each of the first to fourth organic light emitting display panels 100, 200, 300, and 400 in a widthwise direction may be M, and a width in a lengthwise direction may be N.

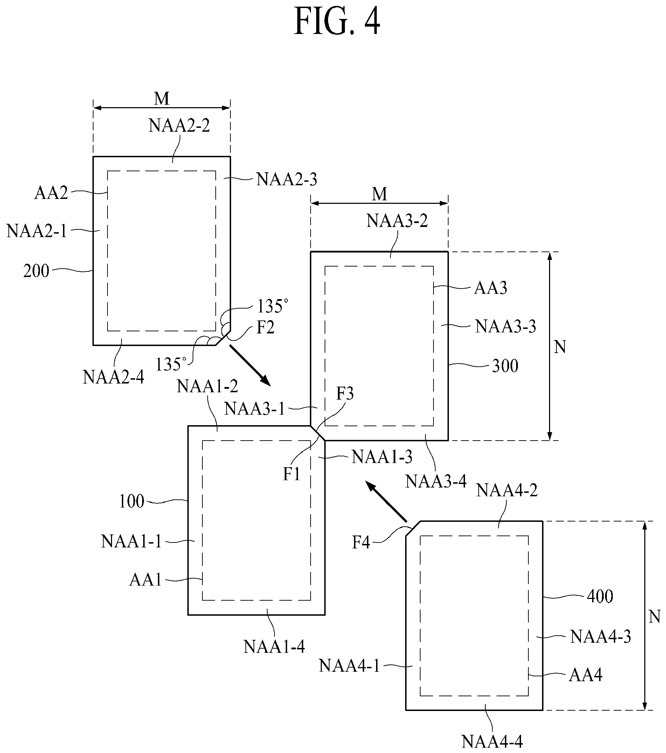

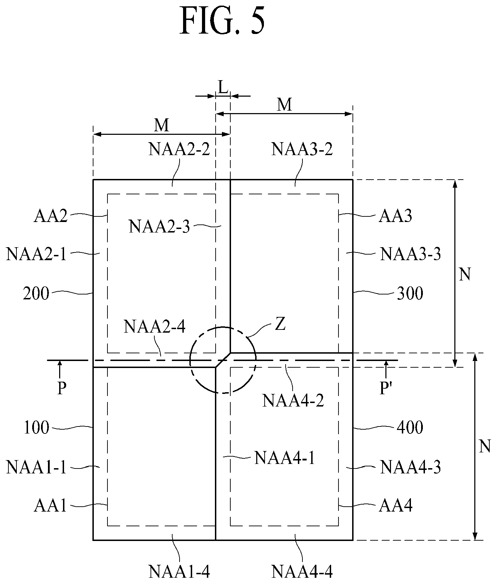

FIG. 4 is an exemplary diagram illustrating two organic light emitting display panels disposed on the same plane to face each other, according to an embodiment of the present disclosure, and FIG. 5 is an exemplary diagram illustrating two organic light emitting display panels disposed on the two organic light emitting display panels of FIG. 4 to face each other, according to an embodiment of the present disclosure.

Hereinafter, a method of manufacturing a tiling display device according to an embodiment of the present disclosure will be described. In description below, details which are the same as or similar to the above-described details are omitted or will be briefly described.

As described above, the organic light emitting display panel according to an embodiment of the present disclosure may be defined by a plurality of data lines and a plurality of gate lines and may include a display area, where a plurality of pixels each including an OLED are provided, and a non-display area which is disposed outside the display area to surround the display area. The non-display area may include a first non-display area, a second non-display area, a third non-display area, and a fourth non-display area. A portion of at least one of a first corner where the first non-display area and the second non-display area are adjacent to each other, a second corner where the second non-display area and the third non-display area are adjacent to each other, a third corner where the third non-display area and the fourth non-display area are adjacent to each other, and a fourth corner where the fourth non-display area and the first non-display area are adjacent to each other may be cut.

The tiling display device according to an embodiment of the present disclosure may include at least four organic light emitting display panels. Hereinafter, as illustrated in FIGS. 3 to 5, a tiling display device including four organic light emitting display panels will be described as an example of the present disclosure.

The tiling display device according to an embodiment of the present disclosure may include the first organic light emitting display panel 100, the second organic light emitting display panel 200, the third organic light emitting display panel 300, and the fourth organic light emitting display panel 400.

In the first organic light emitting display panel 100, a portion of the second corner X1-2 may be cut. In the second organic light emitting display panel 200, a portion of the third corner X2-3 may be cut. In the third organic light emitting display panel 300, a portion of the fourth corner X3-4 may be cut. In the fourth organic light emitting display panel 400, a portion of the first corner X4-1 may be cut.

First, as illustrated in FIG. 3, the first organic light emitting display panel 100 and the third organic light emitting display panel 300 may be disposed in order for the second corner X1-2 of the first organic light emitting display panel 100 to face the fourth corner X3-4 of the third organic light emitting display panel 300.

Moreover, the second organic light emitting display panel 200 and the fourth organic light emitting display panel 400 may be disposed in order for the third corner X2-3 of the second organic light emitting display panel 200 to face the first corner X4-1 of the fourth organic light emitting display panel 400.

Two angles between both ends of a cut surface of one cut corner of the first to fourth corners of each of the first to fourth organic light emitting display panels 100, 200, 300, and 400 and sides respectively contacting the both ends may each be 135 degrees as illustrated in FIG. 4.

In this case, a cut fragment of each of the cut corners may be an isosceles triangle. However, the two angles between the both ends of the cut surfaces and the sides respectively contacting the both ends may be various angles without being limited to 135 degrees.

For example, as illustrated in FIG. 3, in a case where a cut surface of the second corner X1-2 of the first organic light emitting display panel 100 and a cut surface of the fourth corner X3-4 of the third organic light emitting display panel 300 are disposed to face each other, if the cut surfaces are disposed in parallel, the tiling display device may be wholly tetragonal in shape.

To provide an additional description, if cut surfaces of corners facing each other can be disposed in parallel, an angle formed by the cut surfaces may be variously changed.

Next, as illustrated in FIG. 4, the first organic light emitting display panel 100 and the third organic light emitting display panel 300 may be disposed so that the second corner X1-2 of the first organic light emitting display panel 100 and the fourth corner X3-4 of the third organic light emitting display panel 300 contact each other on the same plane,

In this case, a cut surface F1 of the second corner X1-2 of the first organic light emitting display panel 100 may contact a cut surface F3 of the fourth corner X3-4 of the third organic light emitting display panel 300.

Finally, as illustrated in FIG. 5, the second organic light emitting display panel 200 and the fourth organic light emitting display panel 400 may be disposed on the first organic light emitting display panel 100 and the third organic light emitting display panel 300 which contact each other through a process described above with reference to FIG. 4, so that the third corner X2-3 of the second organic light emitting display panel 200 contacts the first corner X4-1 of the fourth organic light emitting display panel 400.

In this case, a cut surface F2 of the third corner X2-3 of the second organic light emitting display panel 200 may contact a cut surface F4 of the first corner X4-1 of the fourth organic light emitting display panel 400.

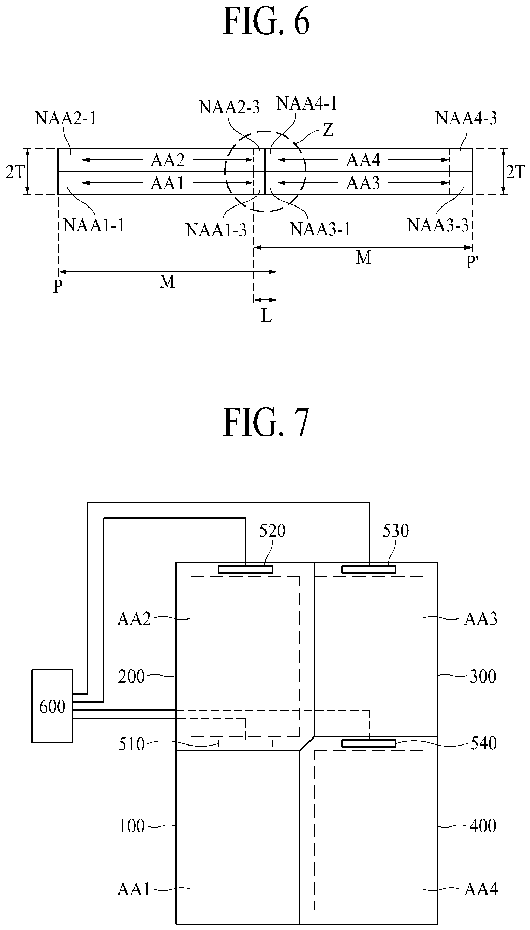

FIG. 6 is an exemplary diagram illustrating a cross-sectional surface taken along line P-P' illustrated in FIG. 5.

A width L of a seam area of the tiling display device manufactured through a process described above with reference to FIGS. 3 to 5 may be a width of a non-display area of each of the organic light emitting display panels.

Moreover, when it is assumed that a thickness of each of the first to fourth organic light emitting display panels 100, 200, 300, and 400 is T, a thickness of an overlap area Z where the four organic light emitting display panels 100, 200, 300, and 400 overlap may be 2T, and moreover, a thickness of an area where two organic light emitting display panels overlap may be 2T.

Therefore, a thickness deviation occurs in the overlap area Z and a portion other than the overlap area Z.

For example, the first organic light emitting display panel 100 and the second organic light emitting display panel 200 may have a height difference equal to 1T, there is no height difference between the first organic light emitting display panel 100 and the third organic light emitting display panel 300, and the first organic light emitting display panel 100 and the fourth organic light emitting display panel 400 may have a height difference equal to 1T.

Moreover, the second organic light emitting display panel 200 and the first organic light emitting display panel 100 may have a height difference equal to 1T, the second organic light emitting display panel 200 and the third organic light emitting display panel 300 may have a height difference equal to 1T, and there is no height difference between the second organic light emitting display panel 200 and the fourth organic light emitting display panel 400.

Moreover, there is no height difference between the third organic light emitting display panel 300 and the first organic light emitting display panel 100, the third organic light emitting display panel 300 and the second organic light emitting display panel 200 may have a height difference equal to 1T, and the third organic light emitting display panel 300 and the fourth organic light emitting display panel 400 may have a height difference equal to 1T.

Moreover, the fourth organic light emitting display panel 400 and the first organic light emitting display panel 100 may have a height difference equal to 1T, there is no height difference between the fourth organic light emitting display panel 400 and the second organic light emitting display panel 200, and the fourth organic light emitting display panel 400 and the third organic light emitting display panel 300 may have a height difference equal to 1T.

Therefore, in the tiling display device, a height difference between the organic light emitting display panels may be a maximum of 1T.

However, in the related art tiling display device illustrated in FIG. 2, a height difference between the organic light emitting display panels may be a maximum of 3T.

Therefore, a user looking at the tiling display device according to an embodiment of the present disclosure cannot feel or less feels a height difference between the organic light emitting display panels. Accordingly, the user cannot feel or less feels a sense of distance of an image displayed by each of the organic light emitting display panels.

FIG. 7 is an exemplary diagram illustrating a tiling display device according to an embodiment of the present disclosure. Particularly, FIG. 7 is an exemplary diagram illustrating in more detail the tiling display device described above with reference to FIGS. 3 to 6. In description below, therefore, details which are the same as or similar to the details described above with reference to FIGS. 3 to 6 are omitted or will be briefly described.

The tiling display device according to an embodiment of the present disclosure may include a first organic light emitting display device, a second organic light emitting display device, a third organic light emitting display device, a fourth organic light emitting display device, and a controller 600 that controls the first to fourth organic light emitting display devices.

The first organic light emitting display device may include the first organic light emitting display panel 100 and a first driver 500 that drives the gate lines and the data lines included in the first organic light emitting display panel 100.

The second organic light emitting display device may include the second organic light emitting display panel 200 and a second driver 520 that drives the gate lines and the data lines included in the second organic light emitting display panel 200.

The third organic light emitting display device may include the third organic light emitting display panel 300 and a third driver 530 that drives the gate lines and the data lines included in the third organic light emitting display panel 300.

The fourth organic light emitting display device may include the fourth organic light emitting display panel 400 and a fourth driver 540 that drives the gate lines and the data lines included in the fourth organic light emitting display panel 400.

Each of the first fourth drivers 510, 520, 530, and 540 may be included in or mounted on at least one of the respective non-display areas of the first to fourth organic light emitting display panels 100, 200, 300, and 400.

Each of the first to fourth organic light emitting display panels 100, 200, 300, and 400 respectively configuring the first to fourth organic light emitting display devices may be defined by the data lines and the gate lines and may include a display area, where a plurality of pixels each including an OLED are provided, and a non-display area which is disposed outside the display area to surround the display area.

The non-display area may include a first non-display area, a second non-display area, a third non-display area, and a fourth non-display area.

A portion of at least one of a first corner where the first non-display area and the second non-display area are adjacent to each other, a second corner where the second non-display area and the third non-display area are adjacent to each other, a third corner where the third non-display area and the fourth non-display area are adjacent to each other, and a fourth corner where the fourth non-display area and the first non-display area are adjacent to each other may be cut.

For example, in the first to fourth organic light emitting display panels 100, 200, 300, and 400 illustrated in FIG. 7, the corners may be cut as follows. In the first organic light emitting display panel 100, a portion of the second corner X1-2 may be cut. In the second organic light emitting display panel 200, a portion of the third corner X2-3 may be cut. In the third organic light emitting display panel 300, a portion of the fourth corner X3-4 may be cut. In the fourth organic light emitting display panel 400, a portion of the first corner X4-1 may be cut.

The fourth non-display area NAA2-4 of the second organic light emitting display panel 200 configuring the second organic light emitting display device may overlap an upper end of the second non-display area NAA1-2 of the first organic light emitting display panel 100 configuring the first organic light emitting display device.

The first non-display area NAA4-1 of the fourth organic light emitting display panel 400 configuring the fourth organic light emitting display device may overlap an upper end of the third non-display area NAA1-3 of the first organic light emitting display panel 100 configuring the first organic light emitting display device.

The third non-display area NAA2-3 of the second organic light emitting display panel 200 configuring the second organic light emitting display device may overlap an upper end of the first non-display area NAA3-1 of the third organic light emitting display panel 300 configuring the third organic light emitting display device.

The second non-display area NAA4-2 of the fourth organic light emitting display panel 400 configuring the fourth organic light emitting display device may overlap an upper end of the fourth non-display area NAA3-4 of the third organic light emitting display panel 300 configuring the third organic light emitting display device.

A portion of the second corner X1-2 of the first organic light emitting display panel 100 configuring the first organic light emitting display device, a portion of the third corner X2-3 of the second organic light emitting display panel 200 configuring the second organic light emitting display device, a portion of the fourth corner X3-4 of the third organic light emitting display panel 300 configuring the third organic light emitting display device, and a portion of the first corner X4-1 of the fourth organic light emitting display panel 400 configuring the fourth organic light emitting display device may be cut.

In this case, a cut surface F1 of the second corner X1-2 of the first organic light emitting display panel 100 configuring the first organic light emitting display device may face a cut surface F3 of the fourth corner X3-4 of the third organic light emitting display panel 300 configuring the third organic light emitting display device.

A cut surface F2 of the third corner X2-3 of the second organic light emitting display panel 200 configuring the second organic light emitting display device may face a cut surface F4 of the first corner X4-1 of the fourth organic light emitting display panel 400 configuring the fourth organic light emitting display device.

The cut surface F1 of the second corner X1-2 of the first organic light emitting display panel 100 configuring the first organic light emitting display device may be parallel with the cut surface F3 of the fourth corner X3-4 of the third organic light emitting display panel 300 configuring the third organic light emitting display device.

The cut surface F2 of the third corner X2-3 of the second organic light emitting display panel 200 configuring the second organic light emitting display device may be parallel with the cut surface F4 of the first corner X4-1 of the fourth organic light emitting display panel 400 configuring the fourth organic light emitting display device.

The controller 600 may control the first to fourth drivers 510, 520, 530, and 540 to allow the first to fourth organic light emitting display devices to display one image.

To this end, the controller 600 may distribute pieces of video data, transmitted from an external system, to the first to fourth drivers 510, 520, 530, and 540.

Moreover, the controller 600 may generate timing control signals and may transmit the timing control signals to the first to fourth drivers 510, 520, 530, and 540, so as to sequentially drive the first to fourth drivers 510, 520, 530, and 540.

As described above, according to the embodiments of the present disclosure, a thickness of the seam area of the tiling display device is reduced, and a thickness deviation in each area of the tiling display device is reduced.

Therefore, the quality of an image displayed by the tiling display device is enhanced.

It will be apparent to those skilled in the art that various modifications and variations can be made in the present disclosure without departing from the scope of the disclosures. Thus, it is intended that the present disclosure covers the modifications and variations of this disclosure provided they come within the scope of the appended claims.

## Claims

1. An organic light emitting display panel (100, 200, 300, 400) comprising:
a display area (AA1, AA2, AA3, AA4) where a plurality of pixels each including an organic light emitting diode are provided; and
a non-display area disposed outside the display area (AA1, AA2, AA3, AA4) to surround the display area (AA1, AA2, AA3, AA4),
wherein
the non-display area comprises a first non-display area (NAA1-1, NAA2-1, NAA3-1, NAA4-1), a second non-display area (NAA1-2, NAA2-2, NAA3-2, NAA4-2), a third non-display area (NAA1-3, NAA2-3, NAA3-3, NAA4-3), and a fourth non-display area (NAA1-4, NAA2-4, NAA3-4, NAA4-4), and
a portion of at least one of a first corner (X4-1) where the first non-display area (NAA4-1) and the second non-display area (NAA4-2) are adjacent to each other, a second corner (X1-2) where the second non-display area (NAA1-2) and the third non-display area (NAA1-3) are adjacent to each other, a third corner (X2-3) where the third non-display area (NAA2-3) and the fourth non-display area (NAA2-4) are adjacent to each other, and a fourth corner (X3-4) where the fourth non-display area (NAA3-4) and the first non-display area (NAA3-1) are adjacent to each other is cut.

2. The organic light emitting display panel of claim 1, wherein each of two angles between both ends of a cut surface of one cut corner of the first to fourth corners (X4-1, X1-2, X2-3, X3-4) and sides respectively contacting the both ends is 135 degrees.

3. A tiling display device comprising:
a first organic light emitting display device;
a second organic light emitting display device;
a third organic light emitting display device;
a fourth organic light emitting display device; and
a controller (600) configured to control the first to fourth organic light emitting display devices,
wherein
the first to fourth organic light emitting display devices comprise, respectively, first to fourth organic light emitting display panels (100, 200, 300, 400) according to claim 1 or 2.

4. The tiling display device of claim 3, wherein
the fourth non-display area (NAA2-4) of the second organic light emitting display panel (200) overlaps an upper end of the second non-display area (NAA1-2) of the first organic light emitting display panel (100),
the first non-display area (NAA4-1) of the fourth organic light emitting display panel (400) overlaps an upper end of the third non-display area (NAA1-3) of the first organic light emitting display panel (100),
the third non-display area (NAA2-3) of the second organic light emitting display panel (200) overlaps an upper end of the first non-display area (NAA3-1) of the third organic light emitting display panel (300),
the second non-display area (NAA4-2) of the fourth organic light emitting display panel (400) overlaps an upper end of the fourth non-display area (NAA3-4) of the third organic light emitting display panel (300), and
a portion of the second corner (X1-2) of the first organic light emitting display panel (100), a portion of the third corner (X2-3) of the second organic light emitting display panel (200), a portion of the fourth corner (X3-4) of the third organic light emitting display panel (300), and a portion of the first corner (X4-1) of the fourth organic light emitting display panel (400) are cut.

5. The tiling display device of claim 4, wherein
a cut surface of the second corner (X1-2) of the first organic light emitting display panel (100) faces a cut surface of the fourth corner (X3-4) of the third organic light emitting display panel (300), and
a cut surface of the third corner (X2-3) of the second organic light emitting display panel (200) faces a cut surface of the first corner (X4-1) of the fourth organic light emitting display panel (400).

6. The tiling display device of claim 4 or 5, wherein
a cut surface of the second corner (X1-2) of the first organic light emitting display panel (100) is parallel with a cut surface of the fourth corner (X3-4) of the third organic light emitting display panel (300), and
a cut surface of the third corner (X2-3) of the second organic light emitting display panel (200) is parallel with a cut surface of the first corner (X4-1) of the fourth organic light emitting display panel (400).
